# EUROPEAN PATENT SPECIFICATION

(11) **EP 0 401 743 B1**
(45) Date of publication and mention of the grant of the patent: **07.01.1998**
(21) Application number: 90110604.7
(22) Date of filing: 05.06.1990
(51) Int. Cl.: H01L 23/427, H01L 23/473

(54) **Electrically insulated heat pipe type cooling apparatus for semiconductor**
Kühlvorrichtung mit elektrisch isoliertem Wärmerohr für Halbleiter
Dispositif de refroidissement par caloduc pour semi-conducteur

(30) Priority: 08.06.1989 JP 145769/89
(43) Date of publication of application: 12.12.1990
(73) Proprietor: THE FURUKAWA ELECTRIC CO., LTD., Tokyo (JP)
(72) Inventor: Murase, Takashi, Yokohama-shi, Kanagawa-ken (JP)
(74) Representative: Boeters, Hans Dietrich, Dr.

(56) References cited:
- DE-A- 3 327 125
- PT/ELEKTROTECHNIEK ELEKTRONICA, vol. 42, no. 12, December 1987, pages 45-49, Rijswijk, NL; M.C. VAN DER WALLE: "Warmtepijpkoeling voor halfgeleidercomponenten"
- IBM TECHNICAL DISCLOSURE BULLETIN, vol. 20, no. 5, October 1977, pages 1769-1771, New York, US; B.T.CLARK et al.:"Cooling device for multilayer ceramic modules"
- PATENT ABSTRACTS OF JAPAN, vol. 10, no. 299 (M-524), 11th October 1986; & JP-A-61 110 883
- PATENT ABSTRACTS OF JAPAN, vol. 8, no. 256 (E-280)[1693], 22nd November 1984; & JP-A-59 130 450 (NIPPON DENKI K.K.) 27-07-1984

## Description

### FIELD OF THE INVENTION

This invention relates to an electrically insulated heat pipe type cooling apparatus for a semiconductor, and more particularly to electrically insulated heat pipe type cooling apparatus that is adapted to cool a power semiconductor, such as a thyristor or the like, by water, with high performance and electrical safety.

### BACKGROUND OF THE INVENTION

A heat pipe for a semiconductor that is used for cooling a power transistor generally is composed of pipes, fins mounted at one end of the pipes so as to serve as a heat dissipation section, and semiconductor mounting metal blocks mounted at the other end of each pipe so as to act as a heat absorption section, and insulation cylinders positioned at the intermediate portion of the pipes, to connect the pipes to each other, as disclosed in Japanese Patent Application (OPI) No. 293654/1987. In the so-constructed conventional heat pipe, heat generated from the semiconductor is transferred through the metal block to the heat pipe and is transferred to the fins of the heat dissipation section by the heat pipe effect. This results in the heat being outwardly dissipated or discharged by natural convection and/or forced convection by a fan or the like.

In recent years semiconductor of a high density and a mass storage capacity has been proposed and manufactured. The development of such a semiconductor creates a need for a cooling apparatus capable of exhibiting better cooling efficiency to cool the semiconductor.

Conventionally, a water-cooled-type cooling apparatus has been used for directly cooling a semiconductor. The water-cooled cooling apparatus is generally constructed in such a manner as shown in Fig. 7. More particularly, in the cooling apparatus, a metal block 49, of satisfactory thermal conductivity for mounting a semiconductor is provided therein with a passage 50 for cooling water, so that cooing water is guided from an inlet nozzle 51 through the passage 50 to an outlet nozzle 52, to cool a transistor 53 that is generating heat. Unfortunately, the water-cooled-type cooling apparatus is low in cooling efficiency, resulting in an inability to meet the recent requirements for cooling a semiconductor.

An improvement in cooling efficiency of the cooling apparatus requires increasing the length of the passage 50. For this purpose, an approach is proposed in which, as shown in Fig. 8, a passage 55 in a metal block 54 is provided to form a plural of meandering flow. In Fig 8, reference numerals 56 and 57 each designate a nozzle and reference numeral 58 designates a semiconductor.

However, the formation of the passage 55 in the metal block 54 requires much labor and time due to its complicated construction, leading to an increase in manufacturing cost. Also, there was a limitation of cooling efficiency even by this improvement. Thus, the water-cooled-type cooling apparatus fails to not only contribute to manufacturing of a semiconductor of a high density and of a mass storage capacity but also to provide a semiconductor with satisfactory electrical insulation.

The document IBM Technical Disclosure Bulletin, vol. 20, no. 5, October 1977, pages 1769 - 1771, New York, US; B.T. Clark et al.: "Cooling Device for Multilayer Ceramic Modules" discloses a heat pipe type cooling apparatus for a semiconductor comprising at least one heat pipe provided at its intermediate portion with a cylinder, said heat pipe being divided through said intermediate portion into a heat absorption section and a heat dissipation section; said heat absorption section being provided with a metal block for mounting a semiconductor thereon; and said heat dissipation section being provided with a structure immersed into the cooling stream of a heat exchanger.

JP-A-61 110 883 discloses a heat pipe type cooling apparatus for cooling a semiconductor with a plurality of heat pipe tubes with the one ends connected to a heat absorption section and the other ends connected to a heat dissipation section, wherein the intermediate portion of the heat pipe tubes is flexible and electrically insulating.

The known heat pipe type cooling devices exhibit the problem, that the cooling in the heat dissipation section is not uniform.

### BRIEF SUMMARY OF THE INVENTION

It is therefore an object of the present invention to provide a heat pipe type cooling apparatus, wherein a constant or uniform cooling effect is achieved.

The above object is solved by the features of present claim 1. The dependent claim 2 is subject of a preferred embodiment of the invention.

The invention relates to an electrically insulated heat pipe type cooling apparatus for a semiconductor comprising at least one heat pipe, said heat pipe being divided into a heat absorption section, and a heat dissipation section with an intermediate portion therebetween, the intermediate portion of said heat pipe being provided with an electrically insulating cylinder; a metal block for mounting a semiconductor thereon, said block being provided at the heat absorption section; a water-cooled jacket structure, said jacket structure being provided at the heat dissipation section such that the water-cooled jacket surrounds said dissipation section said water-cooled structure having a single water inlet and a single water outlet for the flow of cooling waters to the jacket structure; and flow control means within said water-cooled jacket for controlling flow of cooling water through the jacket, wherein said flow control means comprises at least one baffle plate in the interior of the water-cooled jacket the at least one baffle plate controlling the flow of water from the single inlet to the single outlet of the water-cooled jacket.

Further in the electrically insulated heat pipe type cooling apparatus for a semiconductor according to the present invention a plurality of said heat pipes are arranged.

### BRIEF DESCRIPTION OF THE DRAWINGS

These and other objects and many of the attendant advantages of the present invention will be readily appreciated as they become better understood by reference to the following detailed description when considered in connection with the accompanying drawings, wherein:
Fig. 1 is a front elevation view showing an embodiment of an electrically insulated heat pipe type cooling apparatus for a semiconductor according to the present invention;
Fig. 2 is a side elevation view of the heat pipe type cooling apparatus shown in Fig. 1;
Fig. 3 is a front elevation view showing a water-cooled jacket in another embodiment of an electrically insulated heat pipe type cooling apparatus for a semiconductor according to the present invention;
Fig. 4 is a front elevation view showing a further embodiment of an electrically insulated heat pipe type cooling apparatus for a semiconductor according to the present invention;
Fig. 5(a) is a front elevation view showing a water cooling apparatus cooled jacket in still another embodiment of an electrically insulated heat pipe type cooling apparatus for a semiconductor according to the present invention;
Fig. 5(b) is a fragmentary enlarged view of the heat pipe type of the water-cooled jacket shown in Fig. 5(a);

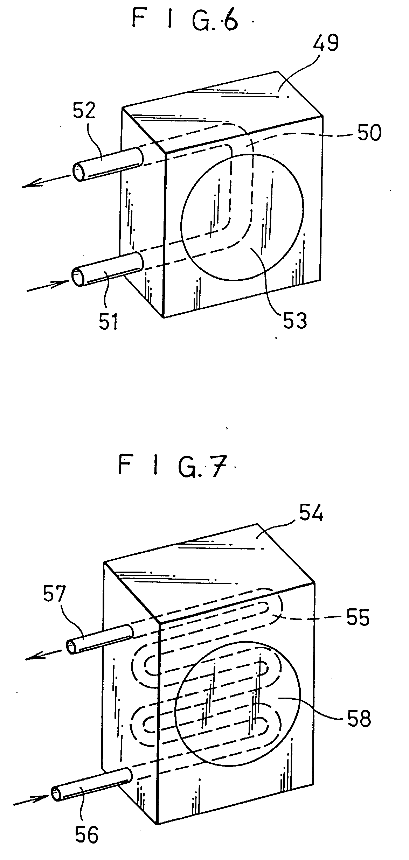

Figs. 6 and 7 each are a perspective view showing a conventional cooling apparatus for a semiconductor.

### DETAILED DESCRIPTION OF THE INVENTION

The present invention provides an electrically insulated heat pipe type cooling apparatus for a semiconductor, according to claim 1.

In the present invention, the metal pipes (hereinafter referred to as "first metal pipes") of the heat dissipation section of the heat pipe insulated electrically by insulation cylinder comprise a water-cooled jacket made of corrosion-resistant material, such as copper, stainless steel, or synthetic resin, to thereby cause heat generated from a semiconductor and transferred to the heat pipe type to be discharged with high efficiency.

The electrical insulation cylinder made by ceramics, for example, alumina is interposedly arranged between the first metal pipes for the heat dissipation and metal pipes (hereinafter referred to as "second metal pipe") for the heat absorption section, to connect the first and second pipes to each other. Also, in the present invention, liquid fluorocarbon, which likewise exhibits electrical insulation properties, may be used as an operating fluid. Such construction of the present invention permits the heat pipe to be contacted directly by water, while preventing the potential of the semiconductor affecting the first metal pipes, so that the heat pipe type cooling apparatus of the present invention substantially improves cooling efficiency.

The first and second metal pipes each may be made of copper, stainless steel, or the like. The pipes each are subject on the inner surface thereof the groove processing or cross groove processing, resulting in improving heat absorption and heat dissipation due to boiling and condensation actions. Further, the first and second metal pipes may be formed into diameters or shapes different from each other, to thereby adjust or control the heat absorption and/or dissipation. The water-cooled structure may be made of corrosion-resistant metal, such as copper, copper alloy, aluminum, stainless steel, and synthetic resin. Moreover, the water-cooled jacket is provided therein with at least one baffle plate to keep the cooling effect uniformly. The number of heat pipes is preferably 2 to 10, more preferably 2 to 8, but the present invention is not restricted to them. According to a cooling capacity to be required, a plurality of heat pipes may be arranged lengthwise and breadthwise in an water cooled jacket in this invention.

### DETAILED DESCRIPTION OF THE PREFERRED EMBODIMENTS

The present invention will be described hereinafter with reference to the accompanying drawings.

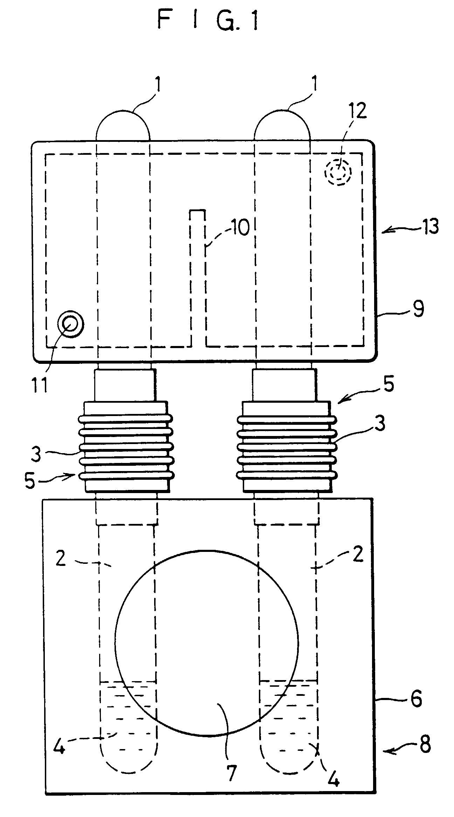

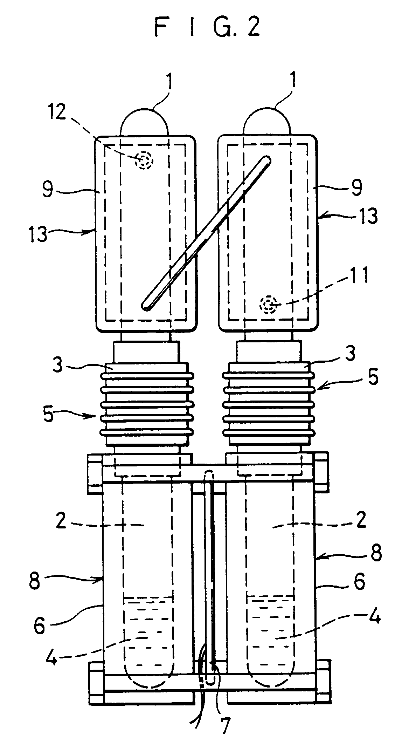

Figs. 1 and 2 illustrate an embodiment of an electrically insulated heat pipe type cooling apparatus for a semiconductor according to the present invention in a front elevation view and side elevation view, respectively. The heat pipe type cooling apparatus of the illustrated embodiment includes first metal pipes 1 and 1, each open at one end, and second metal pipes 2 and 2, each likewise open at one end. The first pipes 1 and 1 and second pipes 2 and 2 are connected to each other through insulation cylinders 3 and 3, in such a manner that their open ends are opposite from each other, respectively, and each may be formed of copper with an outer diameter of, for example, about 22.23 mm. The insulation cylinders 3 and 3 may be formed of aluminum. Operating fluids 4 and 4 of liquid fluorocarbon having electrical insulation properties in predetermined amounts are sealed in the so connected pipes. Thus the heat pipes 5 and 5 are formed. The second metal pipes 2 and 2 of the heat pipes 5 and 5 are mounted in a metal block 6, which may be formed of copper. On the outer surface of the block 6 is mounted semiconductor 7, such as a thyristor or the like, resulting in a heat absorption section 8 being formed.

The first metal pipes 1 and 1 of the heat pipes 5 and 5 each are inserted in a water-cooled jacket 9, in a manner to project from the upper end thereof. The water-cooled jacket 9 may be made of stainless steel that is, for example, 1.0 mm in thickness. In the water-cooled jacket 9 is arranged a baffle plate 10, so as to be positioned between the metal pipes 1 and 1. Also, the water-cooled jacket 9 is provided at the left corner of its front surface with an inlet nozzle 11, through which to feed water into the jacket 9, and at the right corner of its back surface with an outlet nozzle 12, through which to discharge water from the jacket 9 (Fig. 1). Thus a cooling section 13 is formed.

In cooling apparatus described above, usually a semiconductor 7 is put between heat absorption sections 8 and 8 and then pressed suitably by clamp means. Heat generated from the semiconductor 7 is transmitted or transferred through the metal block 6 to the second metal pipes 2 and 2, to cause the operating fluids 4 and 4 to be evaporated, resulting in heat transfer to the first or upper metal pipes 1 and 1, such heat being carried out through the evaporated liquids. Water introduced through the inlet nozzle 11 into the jacket 9 and then discharged therefrom through the outlet nozzle 12 serves to directly cool the upper pipes 1 and 1 in the water-cooled jacket 9, so that the cooling of the pipes may be accomplished with high efficiency. The baffle plate 10 functions to control the flowing of water in the jacket 9.

The heat pipes 5 and 5, as described above, are provided at their intermediate portions with insulation cylinders 3 and 3, so that the first metal pipes 1 and 1 may be electrically insulated from the second metal pipes 2 and 2. This eliminates the necessity of using a specifically prepared water, such as ion-exchanged water or the like, as cooling water. Thus, ordinary tap water or the like may be used for this purpose. Also, the above-described construction permits the area of each of the heat pipes to be enlarged as desired, to thereby increase its cooling area.

In the present invention, the cooling section 13 may be constructed in various manners other than that described above. This is described below.

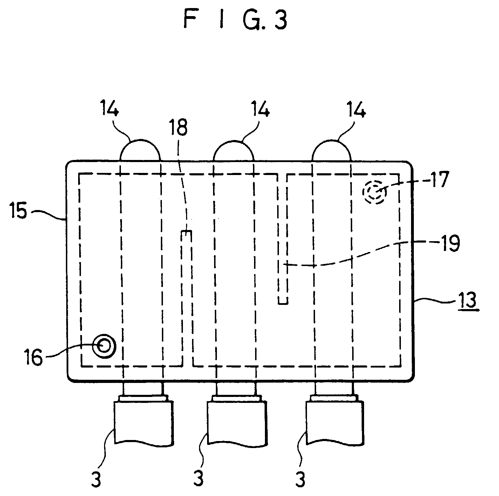

Fig. 3 shows a cooling section 13 in another embodiment of the present invention. More specifically, the cooling section 13 includes first metal pipes 14, 14, and 14 and insulation cylinders 3, 3, and 3. The first pipes 14, 14, and 14 each are inserted into a water-cooled jacket 15, in a manner to be exposed or project from the upper end thereof. The cooling section also includes an inlet nozzle 16 provided at the left lower portion of the front surface of the water-cooled jacket 15, so as to feed cooling water to the jacket 15, and an outlet nozzle 17 provided at the right upper portion of the front surface of the jacket 15, through which to discharge the water from the jacket. In the water-cooled jacket 15 is arranged a baffle plate 18 between the metal pipes 14 and 14, so as to upwardly extend from the bottom of the jacket 15. Likewise, a baffle plate 19 is provided, in a manner to be positioned between the metal pipes 14 and 14 and to downwardly extend form the upper surface of the jacket 15.

Thus, in the embodiment shown in Fig. 3, the number of heat pipes is increased by one and correspondingly the number of baffle plates is increased by one, as compared with those in the embodiment shown in Figs. 1 and 2.

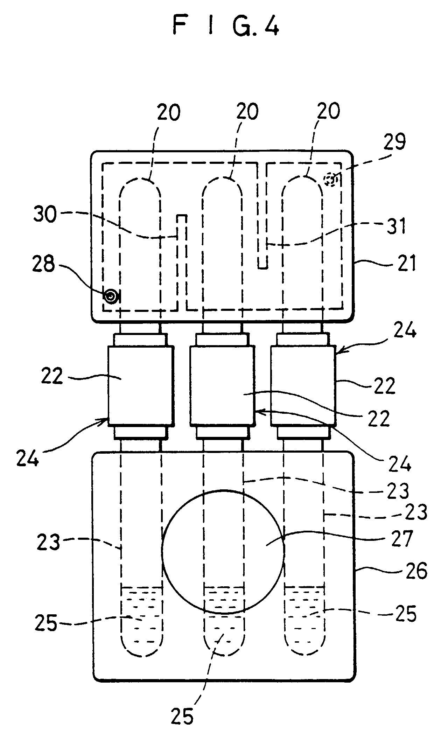

Fig. 4 shows further embodiment of a heat pipe type cooling apparatus according to the present invention. In this embodiment, first metal pipes 20, 20, and 20 each are arranged in a water-cooled jacket 21 so as not to project from the upper end thereof, and bare insulators 22, 22, and 22 are used for an insulation section. The remaining part of the embodiment of Fig. 4 may be constructed in substantially the same manner as that of Figs. 1 and 2. In fig. 4, reference numerals 23, 23, and 23 each designate a second metal pipe, thus, three heat pipes 24, 24, and 24 are formed. In the heat pipes 24, 24 and 24 are contained operating fluids 25, 25, and 25, respectively. Reference numeral 26 indicates a metal block, and 27 indicates a semiconductor mounted (arranged) on the outer surface of the metal block 26. Reference numerals 28 and 29 each designate a baffle plate.

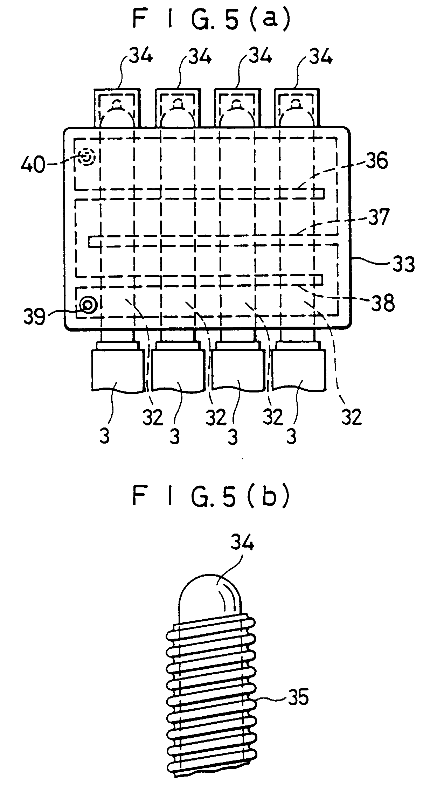

Figs. 5(a) and 5(b) show a cooling section 13 in still another embodiment of an electrically insulated heat pipe type cooler for a semiconductor according to the present invention, in which four heat pipes are arranged in a water-cooled jacket 33 so as to project the upper end thereof from the upper surface of the jacket 33. The projecting ends of each pipe 32 are covered with protective caps 34, 34, 34, and 34, respectively. Also, the cooling section includes four insulation cylinders 3, 3, 3, and 3. The heat pipes 34 each are provided on their outer peripheries with, for example, low fins 35, 35, 35, and 35, for enlarging surface area to improve the convection effect with water, as shown in Fig 5(b). The water-cooled jacket 33 is provided on its side with laterally extending baffle plates 36, 37, and 38, in a manner to be vertically spaced from each another. In this embodiment, cooling water flows in a turbulent flow, making cooling more effective. The water-cooled jacket 33 is provided at the lower portion of its front surface with an inlet nozzle 39, through which to feed cooling water to the jacket, and at its upper end with an outlet nozzle 40, through which to discharge from the jacket. The remaining part of the embodiment may be constructed in substantially the same way as the embodiment of Fig. 1.

According to the present invention,industrially remarkable effects can be attained by carrying out the cooling of semiconductor efficiently and electrically safely.

The features of the embodiments are summarized as follows:
1. Capability to make the system for cooling a semiconductor small size and light weight,
2. Superior cooling capacity and high reliability due to using heat pipe,
3. Electrical safety by using electrical insulator between heat absorption section and heat dissipation section,
4. Increased freedom of apparatus design by changing the size and shape of each component such as block, fin, and heat pipe, and
5. Maintenance free due to independent individual component.

## Claims

1. An electrically insulated heat pipe type cooling apparatus for a semiconductor comprising:
at least one heat pipe (5, 24), said heat pipe (5, 24) being divided into a heat absorption section (2, 23), and a heat dissipation section (1, 14, 20, 32) with an intermediate portion (3, 22) therebetween, the intermediate portion (3, 22) of said heat pipe (5, 24) being provided with an electrically insulating cylinder (3, 22);
a metal block (6, 26) for mounting a semiconductor (7, 27) thereon, said block (6, 26) being provided at the heat absorption section (2, 23);
a water-cooled jacket structure (9, 15, 21, 33), said jacket structure being provided at the heat dissipation section (1, 14, 20, 32) such that the water-cooled jacket (9, 15, 21, 33) surrounds said dissipation section (1, 14, 20, 32), said water-cooled structure (9, 15, 21, 33) having a single water inlet (11, 16, 28, 39) and a single water outlet (12, 17, 29, 40) for the flow of cooling water through the jacket structure (9, 15, 21, 33); and
flow control means (10, 18, 19, 30, 31, 36, 37, 38) within said water-cooled jacket (9, 15, 21, 33) for controlling flow of cooling water through the jacket (9, 15, 21, 33), wherein said flow control means (10, 18, 19, 30, 31, 36, 37, 38) comprises at least one baffle plate (10, 18, 19, 30, 31, 36, 37, 38) in the interior of the water-cooled jacket (9, 15, 21, 33), said at least one baffle plate (10, 18, 19, 30, 31, 36, 37, 38) controlling the flow of water from the single inlet (11, 16, 28, 39) to the single outlet (12, 17, 29, 40) of the water-cooled jacket (9, 15, 21, 33).

2. The electrically insulated heat pipe type cooling apparatus for a semiconductor as claimed in claim 1, wherein a plurality of said heat pipes (5, 24) are arranged.

## Patentansprüche

1. Kühlvorrichtung mit elektrisch isoliertem Wärmerohr für Halbleiter, die aufweist:
mindestens ein Wärmerohr (5, 24), wobei das Wärmerohr (5, 24) in einen wärmeabsorbierenden Abschnitt (2, 23) und einen wärmedissipierenden Abschnitt (1, 14, 20, 32) mit einem dazwischenliegenden Zwischenabschnitt (3, 22) unterteilt ist, wobei der Zwischenabschnitt (3, 22) des Wärmerohrs (5, 24) mit einem elektrisch isolierenden Zylinder (3, 22) versehen ist;
einen Metallblock (6, 26), um darauf einen Halbleiter (7, 27) zu befestigen, wobei der Block (6, 26) an dem wärmeabsorbierenden Abschnitt (2, 23) vorgesehen ist;
einer wassergekühlten Mantelstruktur(9, 15, 21, 33), wobei die Mantelstruktur (9, 15, 21, 33) an dem wärmedissipierenden Abschnitt (1, 14, 20, 32) angeordnet ist, derart daß der wassergekühlte Mantel (9, 15, 21, 33) den Dissipationsabschnitt (1, 14, 20,, 32) umgibt, wobei die wassergekühlte Struktur (9, 15, 21, 33) einen einzigen Wassereinlaß (11, 16, 28, 39) und einen einzigen Wasserauslaß (12, 17, 29, 40) für den Fluß des Kühlwassers durch die Mantelstruktur (9, 15, 21, 33) aufweist; und
ein flußsteuerndes Mittel (10, 18, 19, 30, 31, 36, 37, 38) innerhalb des wassergekühlten Mantels (9, 15, 21, 33) zum Steuern des Flusses des Kühlwassers durch den Mantel (9, 15, 21, 33), wobei das flußsteuernde Mittel (10, 18, 19, 30, 31, 36, 37, 38) mindestens eine Ablenkplatte (10, 18, 19, 30, 31, 36, 37, 38) im Innern des wassergekühlten Mantels (9, 15, 21, 33) aufweist, wobei die mindestens eine Ablenkplatte (10, 18, 19, 30, 31, 36, 37, 38) den Fluß des Wassers von dem einzigen Einlaß (11, 16, 28, 39) zu dem einzigen Auslaß (12, 17, 29, 40) des wassergekühlten Mantels (9, 15, 21, 33)steuert.

2. Kühlvorrichtung mit elektrisch isoliertem Wärmerohr für Halbleiter nach Anspruch 1, in der eine Vielzahl von Wärmerohren (5, 24) angeordnet sind.

## Revendications

1. Dispositif de refroidissement du type à caloduc isolé électriquement pour semiconducteur, comportant :
au moins un caloduc (5, 24), ledit caloduc (5, 24) étant divisé en un tronçon d'absorption de chaleur (2, 23), et un tronçon de dissipation de chaleur (1, 14, 20, 32), une partie intermédiaire (3, 22) étant agencée entre ceux-ci, la partie intermédiaire (3, 22) dudit caloduc (5, 24) étant munie d'un cylindre électriquement isolant (3, 22),
un bloc métallique (6, 26) destiné au montage d'un semiconducteur (7, 27) sur celui-ci, ledit bloc (6, 26) étant agencé au niveau du tronçon d'absorption de chaleur (2, 23) ;
une structure formant enveloppe refroidie à l'eau (9, 15, 21, 33), ladite structure formant enveloppe étant agencée au niveau du tronçon de dissipation de chaleur (1, 14, 20, 32) de telle sorte que l'enveloppe refroidie à l'eau (9, 15, 21, 33) entoure ledit tronçon de dissipation (1, 14, 20, 32), ladite structure refroidie à l'eau (9, 15, 21, 33) ayant une seule entrée d'eau (11, 16, 28, 39) et une seule sortie d'eau (12, 17, 29, 40) pour l'écoulement d'eau de refroidissement vers la structure formant enveloppe (9, 15, 21, 33) ; et des moyens de commande d'écoulement (10, 18, 19, 30, 31, 36, 37, 38) situés dans ladite enveloppe refroidie à l'eau (9, 15, 21, 33) pour commander l'écoulement de l'eau de refroidissement à travers l'enveloppe (9, 15, 21, 33), dans lequel lesdits moyens de commande d'écoulement (10, 18, 19, 30, 31, 36, 37, 38) comportent au moins une plaque formant déflecteur (10, 18, 19, 30, 31, 36, 37, 38) à l'intérieur de l'enveloppe refroidie à l'eau (9, 15, 21, 33), la au moins une plaque formant déflecteur (10, 18, 19, 30, 31, 36, 37, 38) commandant l'écoulement d'eau à partir de la seule entrée (11, 16, 28, 39) vers la seule sortie (12, 17, 29, 40) de l'enveloppe refroidie à l'eau (9, 15, 21, 33).

2. Dispositif de refroidissement du type à caloduc isolé électriquement pour semiconducteur selon la revendication 1, dans lequel sont agencés plusieurs caloducs (5, 24).
